# FASCICULE DE BREVET EUROPEEN

(11) **EP 3 104 402 B1**
(45) Date de publication et mention de la délivrance du brevet: **24.04.2019**
(21) Numéro de dépôt: 16173192.2
(22) Date de dépôt: 06.06.2016
(51) Int. Cl.: H01L 21/822, H01L 27/06, H01L 21/8234

(54) **REALISATION D'ELEMENTS D'INTERCONNEXIONS AUTO-ALIGNES POUR CIRCUIT INTEGRE 3D**
HERSTELLUNG VON SELBSTAUSGERICHTETEN VERBINDUNGSELEMENTEN FÜR INTEGRIERTEN 3D-SCHALTKREIS
PRODUCTION OF SELF-ALIGNED INTERCONNECTION ELEMENTS FOR 3D INTEGRATED CIRCUIT

(30) Priorité: 09.06.2015 FR 1555237
(43) Date de publication de la demande: 14.12.2016
(73) Titulaire: COMMISSARIAT À L'ÉNERGIE ATOMIQUE ET AUX ÉNERGIES ALTERNATIVES, 75015 Paris (FR)
(72) Inventeur: FENOUILLET-BERANGER, Claire, 38500 Voiron (FR); PREVITALI, Bernard, 38100 Grenoble (FR); ROZEAU, Olivier, 38430 Moirans (FR)
(74) Mandataire: Brevalex

(56) Documents cités:
- EP-A2- 0 075 945
- WO-A1-2014/209278
- US-A- 6 040 223
- US-A1- 2012 256 238
- US-B1- 6 433 609

## Description

### DOMAINE TECHNIQUE

La présente demande concerne le domaine des circuits intégrés dotés de composants répartis sur plusieurs niveaux, en particulier de transistors superposés. De tels dispositifs sont généralement qualifiés de circuits intégrés en 3 dimensions ou « 3D ».

La présente demande vise plus particulièrement la réalisation d'éléments de connexion entre un transistor d'un niveau donné et un élément d'un niveau inférieur.

### ART ANTÉRIEUR

D'une manière générale, dans le domaine des circuits intégrés, on cherche continuellement à augmenter la densité de transistors.

Pour cela, une solution consiste à répartir les transistors sur plusieurs niveaux de couches semi-conductrices superposées. De tels circuits comportent ainsi généralement au moins deux couches semi-conductrices superposées et séparées entre elles par une couche isolante.

Des éléments d'interconnexion traversant cette couche isolante peuvent être prévus pour connecter entre eux les différents niveaux de transistors.

L'encombrement et la répartition des éléments d'interconnexion entre les différents niveaux de composant pose problème.

Pour réaliser une interconnexion entre une électrode, par exemple l'électrode de grille d'un transistor d'un niveau donné avec un élément d'un niveau inférieur à ce niveau donné, il est connu de prévoir une structure de contact qui remonte vers un niveau métallique, s'étend horizontalement dans ce niveau métallique, puis redescend vers le niveau inférieur.

Cette structure pose des problèmes d'encombrement et doit généralement être réalisée en tenant compte d'éventuels défauts d'alignement entre les différents niveaux de composants.

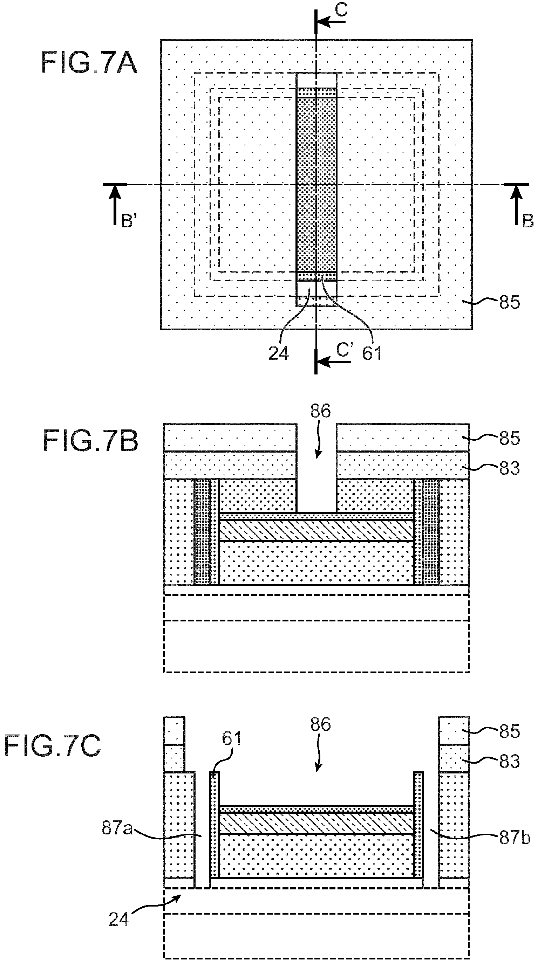

Le document WO 2014/209278 A1 décrit la réalisation d'éléments d'interconnexion de grille permettant de connecter deux niveaux d'un circuit intégré 3D. Dans une variante illustrée dans la figure 7, l'ouverture d'un masque est alignée au dessus d'une région de canal. Une gravure traverse une grille de substitution afin d'exposer un diélectrique de grille au fond d'un via. Ensuite, le diélectrique de grille est gravé au fond du via, alors que les parois latérales de la partie semi-conductrice destinée à servir de région de canal restent couverts du diélectrique de grille. La gravure du via continue à travers un diélectrique entre les niveaux afin d'atterrir sur un élément d'interconnexion. La formation de l'élément d'interconnexion de grille se termine par le dépôt et la planarisation d'un métal. Seul le diélectrique de grille sépare l'élément d'interconnexion de la région de canal.

Le document US 6,040,223 décrit un double espaceur de grille avec une couche trapézoïdale en SiO₂ recouverte d'une couche en Si₃N₄. Les espaceurs en Si₃N₄ protègent le SiO₂ lors de la gravure d'un contact auto-aligné qui s'étend sur l'électrode de grille en polysilicium, afin d'éviter une dégradation des caractéristiques du dispositif FET. Un tel contact est utilisé pour les connexions électriques entre l'électrode de grille et l'une des régions source/drain.

Il se pose le problème de trouver un nouveau procédé de réalisation d'un élément d'interconnexion pour circuit intégré 3D amélioré vis-à-vis d'inconvénients énoncés ci-dessus.

### EXPOSÉ DE L'INVENTION

La présente invention prévoit un procédé selon la revendication 1.

A l'étape a), ladite face latérale du bloc est avantageusement agencée en fonction du positionnement d'une première zone de connexion du niveau inférieur.

Ainsi, la zone isolante latérale réalisée ensuite à l'étape b) est formée sur cette face et est agencée en fonction du positionnement de la première zone de connexion, ce qui permet ensuite de pouvoir réaliser un élément d'interconnexion auto-aligné, qui est très proche de la zone active du transistor de niveau supérieur sans qu'un masque supplémentaire ne soit nécessaire.

La zone isolante latérale peut être formée à l'étape b) de sorte à entourer entièrement le bloc.

Un tel procédé peut permettre de former un élément d'interconnexion constitué uniquement d'une partie qui s'étend contre la face latérale du bloc et éventuellement d'une autre partie qui s'étend en regard de la deuxième couche semi-conductrice et parallèlement à cette dernière, sans qu'il soit nécessaire de passer par un étage supérieur de métal pour prendre le contact électrique.

Le bloc réalisé à l'étape a) peut être formé par gravure d'un empilement de couches.

Selon l'invention, l'électrode est une électrode de grille du transistor.

La zone isolante latérale comprend une première couche diélectrique à base d'un premier matériau diélectrique et une deuxième couche diélectrique à base d'un deuxième matériau diélectrique apte à être gravé de manière sélective vis-à-vis du premier matériau diélectrique.

La première couche diélectrique est disposée en contact de la deuxième couche semi-conductrice et revêtue par la deuxième couche diélectrique.

Ainsi, la première portion de zone isolante latérale retirée à l'étape c) est une portion de la deuxième couche diélectrique gravée sélectivement vis-à-vis de la première couche diélectrique de sorte que le premier matériau diélectrique est conservé entre le trou et la deuxième couche semi-conductrice.

Cela permet de former un élément d'interconnexion avec l'électrode de grille tout en conservant une isolation entre cet élément d'interconnexion et la deuxième couche semi-conductrice. On évite ainsi tout court-circuit entre l'élément d'interconnexion et la zone active du transistor de niveau supérieur.

Une couche de protection peut être disposée sur le niveau inférieur préalablement à la formation du bloc à l'étape a). Comme la zone isolante latérale est formée d'un premier matériau diélectrique et d'un deuxième matériau diélectrique apte à être gravé de manière sélective vis-à-vis du premier matériau diélectrique, la couche de protection peut être avantageusement formée d'un même empilement de matériaux que celui de la zone isolante latérale.

Le procédé peut comprendre en outre des étapes de :
- formation d'au moins un autre trou par gravure d'au moins une autre portion de la zone isolante latérale, l'autre trou étant agencé de sorte à dévoiler une zone de la deuxième couche semi-conductrice destinée à former une région de source ou de drain, et au moins une deuxième zone de connexion du premier niveau,
- remplissage de l'autre trou par un matériau conducteur de sorte à former au moins un autre élément d'interconnexion entre une électrode de source ou de drain du transistor et une deuxième zone de connexion du premier niveau.

On réalise ainsi un élément d'interconnexion auto-aligné entre le niveau inférieur et la grille du transistor du niveau supérieur et un autre élément d'interconnexion auto-aligné entre le niveau inférieur et la source ou le drain de ce même transistor.

La première zone de connexion et la deuxième zone de connexion peuvent être distinctes et non connectées entre elles.

Selon une possibilité de mise en oeuvre du procédé on forme en outre au moins une couche de masquage en regard de la deuxième couche semi-conductrice et au moins un ouverture dans la couche de masquage, l'ouverture suivant un motif de grille, le premier trou étant réalisé à l'étape c) de sorte à communiquer avec l'ouverture, le dépôt à l'étape d) comprenant le remplissage de ladite ouverture par un matériau conducteur de sorte à former une grille du transistor.

On peut ainsi réaliser la grille concomitamment à l'élément d'inter connexion entre l'électrode de grille et la première zone de connexion.

Le bloc formé à l'étape a) peut comprendre une couche de diélectrique de grille disposée sur la deuxième couche semi-conductrice, l'ouverture dévoilant la couche de diélectrique de grille.

On peut ainsi s'affranchir du dépôt d'un diélectrique de grille dans l'ouverture préalablement à l'étape d) de remplissage. Cela peut permettre de conserver l'intégrité du diélectrique.

Comme la zone isolante latérale est formée d'un empilement d'une première couche et deuxième couche diélectrique, la couche de masquage peut être prévue en contact avec la deuxième couche diélectrique et à base du deuxième matériau diélectrique.

Cela permet de réaliser l'ouverture et le trou à l'aide d'une même gravure ou au moins d'un même procédé de gravure.

Avantageusement, après formation de la zone isolante latérale, le procédé peut comprendre des étapes de :
- formation sur la deuxième couche semi-conductrice d'une grille sacrificielle à base d'un matériau sacrificiel, puis
- croissance de régions de source et de drain sur la couche semi-conductrice, puis
- remplacement de la grille sacrificielle par une autre grille, l'autre grille étant formée à l'étape d) à base dudit matériau conducteur.

Dans ce cas, lorsque le matériau sacrificiel n'est pas métallique, par exemple semi-conducteur, on peut éviter une contamination du niveau supérieur notamment lors de la croissance des régions de source et de drain.

Selon une possibilité de mise en oeuvre, on peut prévoir une couche conductrice supplémentaire de plan de masse ou de commande par l'arrière de la tension de seuil du transistor du niveau supérieur.

Dans ce cas, le bloc peut comprendre une couche conductrice entre le niveau supérieur et la deuxième couche semi-conductrice, la couche conductrice étant revêtue par la couche isolante, et étant agencée en outre en regard de la deuxième couche semi-conductrice et de sorte que la couche isolante sépare la deuxième couche semi-conductrice de cette couche conductrice, la couche isolante ayant une épaisseur et étant à base d'un matériau prévus de sorte à permettre un couplage capacitif entre la couche conductrice et la deuxième couche semi-conductrice.

Ainsi, la couche conductrice peut permettre de contrôler la tension de seuil dudit transistor par couplage capacitif en fonction de la manière dont elle est polarisée. Cette couche conductrice peut-être une couche semi-conductrice dopée.

Un tel agencement peut être prévu notamment lorsque le transistor de niveau supérieur est réalisé en technologie FDSOI (« Fully-Depleted Silicon On Insulator »)

La couche conductrice peut être agencée de sorte à dépasser dans le bloc par rapport à la deuxième couche semi-conductrice, de manière à former un décrochement. Cela peut permettre de faciliter la prise de contact.

Selon une possibilité de mise en oeuvre particulière, le procédé peut comprendre en outre, entre l'étape a) et l'étape b) : la formation d'un bouchon isolant contre au moins une autre face latérale du bloc, la face latérale n'étant pas recouverte par le bouchon isolant.

Un mode de réalisation de la présente invention permet de réaliser un circuit intégré doté de plusieurs niveaux de composants électroniques superposés, comprenant :
- un niveau inférieur doté d'au moins un premier composant au moins partiellement formé dans une première couche semi-conductrice,
- un bloc agencé sur le niveau inférieur comprenant une deuxième couche semi-conductrice dans laquelle au moins une région de canal d'au moins un transistor d'un deuxième niveau est formée et une couche isolante agencée entre la première couche semi-conductrice et la deuxième couche semi-conductrice,
- un élément d'interconnexion entre la grille du transistor supérieur et une zone de connexion du niveau inférieur, l'élément d'interconnexion étant formé d'un matériau conducteur s'étendant contre au moins une face latérale du bloc, le matériau conducteur débordant sur une zone de diélectrique de grille parallèlement à la deuxième couche semi-conductrice.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1, 2, 3A-3B, 4A-4B, 5A-5B, 6A-6B, 7A-7C, 8A-8C, 9A-9B, 10A-10C, 11A-11C, 12A-12C, 13A-13D servent à illustrer un exemple de procédé de réalisation d'élément d'interconnexion entre deux niveaux de composants d'un circuit intégré 3D ;
- les figures 14, 15A-15C, 16A-16C illustrent une variante dans laquelle une couche conductrice de plan de masse ou de contrôle par l'arrière du canal d'un transistor de niveau supérieur est prévue ;
- les figures 17A, 17B, 18A, 18B servent à illustrer une autre variante de mise en oeuvre du procédé suivant l'invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « sur », « au-dessus », « verticalement », « latéraux », « latérale », « supérieure » s'appliquent en considérant que la structure est orientée de la façon illustrée dans les figures.

### EXPOSÉ DÉTAILLÉ DE MODES DE RÉALISATION PARTICULIERS

Un exemple de procédé de réalisation d'éléments de connexion pour un circuit intégré en 3 dimensions ou « 3D », va à présent être donné.

Le dispositif peut être réalisé à partir d'un substrat comprenant une première couche semi-conductrice superficielle 11 dans laquelle un ou plusieurs composants d'un premier niveau N₁ de composants électroniques sont prévus.

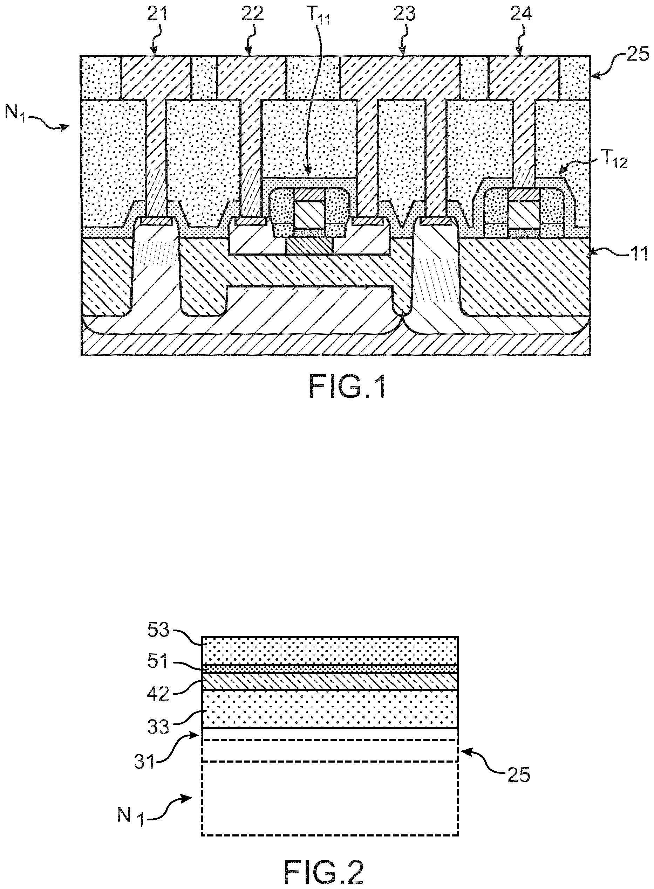

Dans l'exemple illustré sur la figure 1, les composants sont des transistors T₁₁ et T₁₂, en particulier de type MOS (MOS pour « Métal Oxide Semi-conductor ») et ont des régions de canal respectives qui s'étendent dans la première couche semi-conductrice 11.

Une ou plusieurs zones conductrices 21, 22, 23, 24 de connexion appartenant au premier niveau N₁ sont également formées au-dessus des transistors T₁₁, T₁₂ et connectées à ceux-ci. Les zones 21, 22, 23, 24 de connexion sont agencées dans une couche 25 à base d'un matériau diélectrique. Ce matériau peut être un peut être de type communément appelé « low-k », autrement dit à faible diélectrique, tel que par exemple du SiOC.

Après avoir formé le premier niveau N₁ de composants, on réalise, sur ce premier niveau N₁, un empilement de couches recouvrant une ou plusieurs des zones de connexion 21, 22, 23, 24. L'empilement de couches formé sur le premier niveau est ainsi disposé en regard d'une ou plusieurs zones de connexion donnée(s) du premier niveau N₁. Sur la figure 2, le premier niveau Ni et la couche isolante 25 dans laquelle les zones de connexion sont disposées, sont représentées de manière schématique au moyen de traits discontinus.

L'empilement réalisé peut comporter une fine couche 31 de protection prévue de sorte à protéger les zones de connexion du premier niveau d'interconnexion lors d'une ou plusieurs étape(s) ultérieure(s) de gravure. La fine couche 31 de protection peut être formée d'un empilement de plusieurs matériaux diélectriques différents par exemple un empilement bi-couches de SiN et de SiO₂.

Sur la fine couche de protection 31, une couche isolante 33 est formée au-dessus du premier niveau Ni de composants. La couche isolante 33 est disposée entre la première couche semi-conductrice 11 et une deuxième couche semi-conductrice 42 dans laquelle un ou plusieurs composants d'un deuxième niveau N₂ de composants électroniques sont destinés à être réalisés. La couche isolante 33 est ainsi configurée pour réaliser une isolation entre le premier niveau N₁ et le deuxième niveau N₂ de composants.

Au moins un transistor est prévu dans le deuxième niveau N₂ de composants. Ce transistor est par exemple de type MOS (MOS pour « Metal Oxide Semi-conductor »), avec une région de canal prévue dans la deuxième couche semi-conductrice 42.

Une méthode pour former la deuxième couche semi-conductrice 42 peut consister à effectuer un report, par exemple suivant une technique de collage moléculaire, dans lequel un support comprenant la deuxième couche semi-conductrice 42 est reporté sur la couche isolante 33. Ce support peut être lui-même doté d'une couche isolante, par exemple à base d'oxyde de silicium (SiO₂), que l'on met alors en contact avec la couche isolante 33 pour effectuer un collage de type oxyde-oxyde. Selon une variante, on peut reporter la deuxième couche semi-conductrice 42 directement sur la couche isolante 33 par collage moléculaire.

La couche semi-conductrice 42 est revêtue d'une couche de diélectrique 51 de grille qui peut être un matériau « high-k » tel que par exemple du HfO₂.

La couche de diélectrique 51 de grille peut être elle-même revêtue d'une première couche 53 de masquage par exemple à base de nitrure de silicium.

Ensuite, par gravure de l'empilement protégé par la première couche de masquage 53, on forme un bloc 39.

On définit ainsi dans la deuxième couche semi-conductrice 42 une zone active destinée à accueillir une ou plusieurs régions de canal de transistor(s). La gravure de l'empilement peut être réalisée par exemple à l'aide de procédé de gravure sèche. On peut alors se servir de la couche de protection 31 comme d'une couche d'arrêt de gravure.

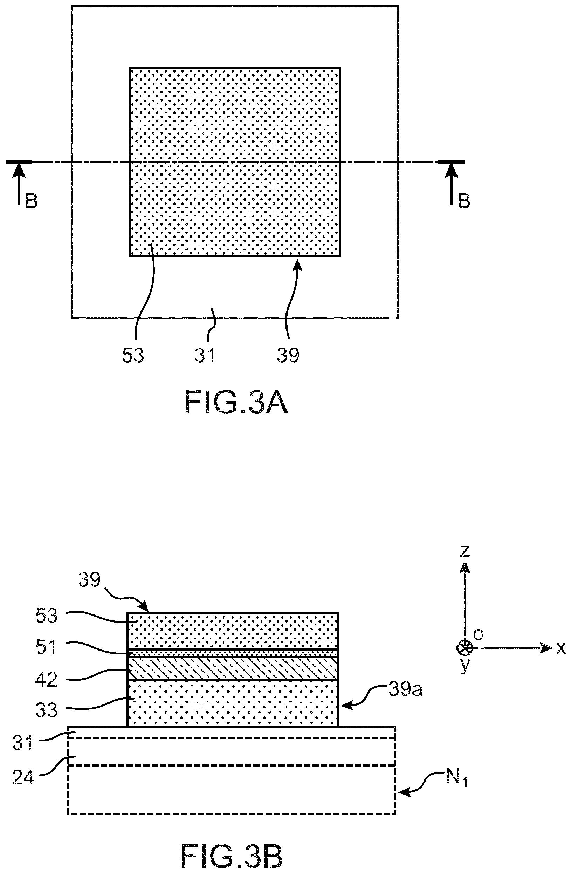

Sur la figure 3A, le bloc 39 formé dans l'empilement une fois gravé jusqu'à la couche de protection 31 est représenté selon une vue de dessus, tandis que ce même bloc 39 est illustré sur la figure 3B selon une vue en coupe suivant un axe B'B.

Le bloc 39 est doté de faces latérales 39a qui, dans cet exemple de réalisation, ont une direction parallèle à une normale au plan principal de la deuxième couche semi-conductrice, le plan principal étant défini ici et dans tout le reste de la description comme un plan passant par la deuxième couche semi-conductrice et parallèle au plan [O, x, y] du repère orthogonal [0 ; x ; y ; z] donné sur la figure 3B, la normale étant parallèle à l'axe z de ce repère. Le positionnement d'au moins une face latérale 39a du bloc 39 est prévu en fonction de celui d'une ou plusieurs des zones de connexion du premier niveau N₁. Dans l'exemple de la figure 3B, une face latérale 39a se trouve à l'aplomb d'une zone de connexion 24 du premier niveau N₁.

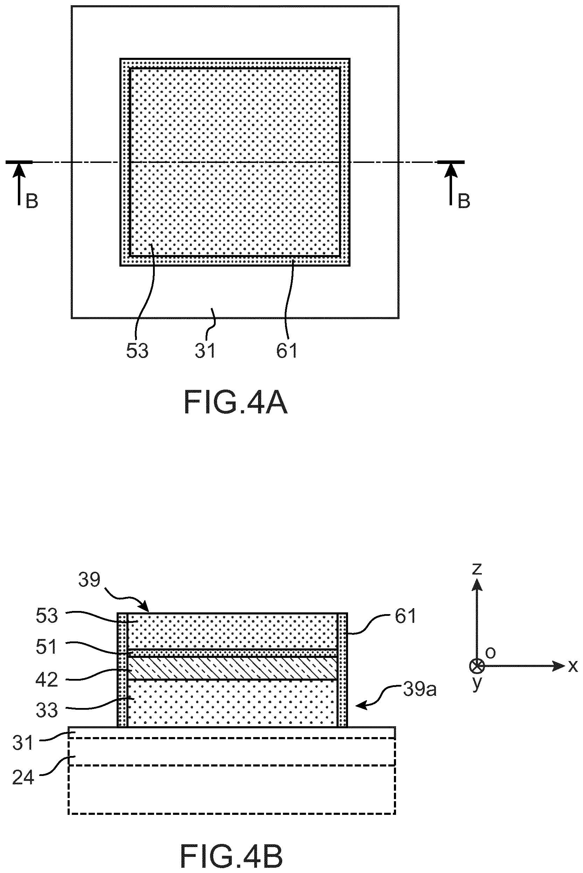

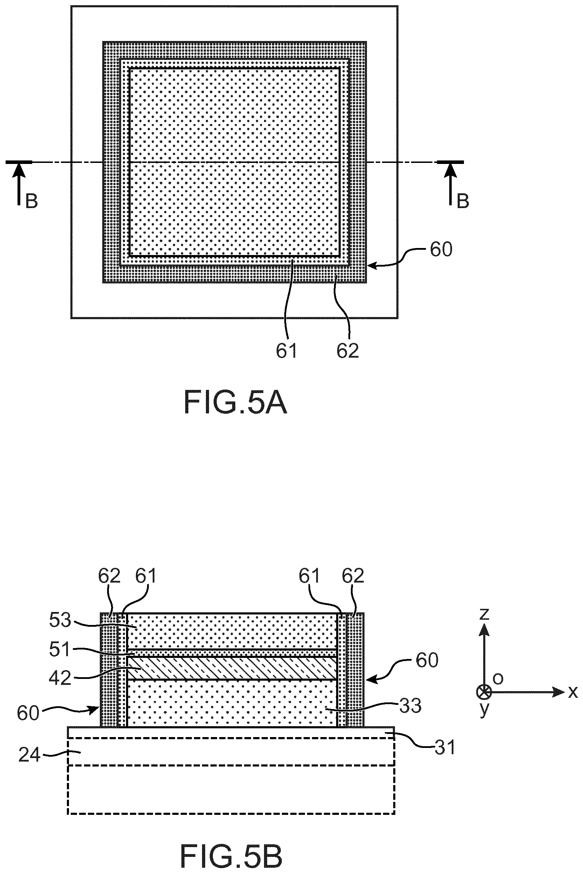

On réalise ensuite une zone isolante 60 dite « latérale » et qui s'étend parallèlement à au moins la face latérale 39a du bloc 39. Selon une possibilité de mise en oeuvre illustrée sur les figures 4A-4B et 5A-5B, cette zone isolante 60 peut être réalisée tout autour du bloc 39 de manière à entourer complètement celui-ci. La zone isolante 60 est destinée à servir à la mise en oeuvre d'au moins un élément de connexion auto-aligné et est formée de plusieurs épaisseurs de matériaux diélectriques différents.

La zone isolante 60 peut être formée tout d'abord par dépôt puis gravure d'une première couche d'un premier matériau diélectrique 61 (figure 4A donnant une vue de dessus et figure 4B donnant une vue en coupe suivant l'axe B'B) puis par dépôt et gravure d'une deuxième couche d'un deuxième matériau diélectrique 62 (figure 5A donnant une vue de dessus, figure 5B donnant une vue en coupe suivant l'axe B'B). Le deuxième matériau diélectrique 62 est choisi de sorte à pouvoir être gravé sélectivement vis-à-vis du premier matériau diélectrique 61. Le premier matériau diélectrique 61 peut être par exemple à base d'oxyde de silicium (SiO₂) tandis que le deuxième matériau diélectrique 62 peut être par exemple à base de nitrure de silicium (SiN). Le premier matériau diélectrique 61 est disposé autour et en contact du bloc 39, tandis le deuxième matériau diélectrique 62 est disposé autour et en contact du premier matériau diélectrique 61. Dans cet exemple, la zone isolante 60 latérale s'étend verticalement contre le bloc 39 et en regard d'une zone de connexion 24 du premier niveau Ni.

Pour permettre de protéger le premier niveau d'interconnexion lors de la réalisation de la zone isolante 60, la couche de protection 31 peut avantageusement comprendre un empilement de matériaux diélectrique similaire à celui formé par les diélectriques 61, 62. Ainsi, dans le cas où le premier matériau diélectrique 61, et le deuxième matériau diélectrique 62 sont respectivement du nitrure de silicium (SiN) et de l'oxyde de silicium (SiO₂) et, la couche de protection 31 peut être par exemple formée d'un empilement d'oxyde de silicium (SiO₂) d'épaisseur comprise par exemple entre 2 et 5nm, recouvert d'une couche d'un autre matériau isolant, par exemple tel que de nitrure de silicium (SiN) pouvant avoir une épaisseur comprise par exemple entre 2 et 5nm.

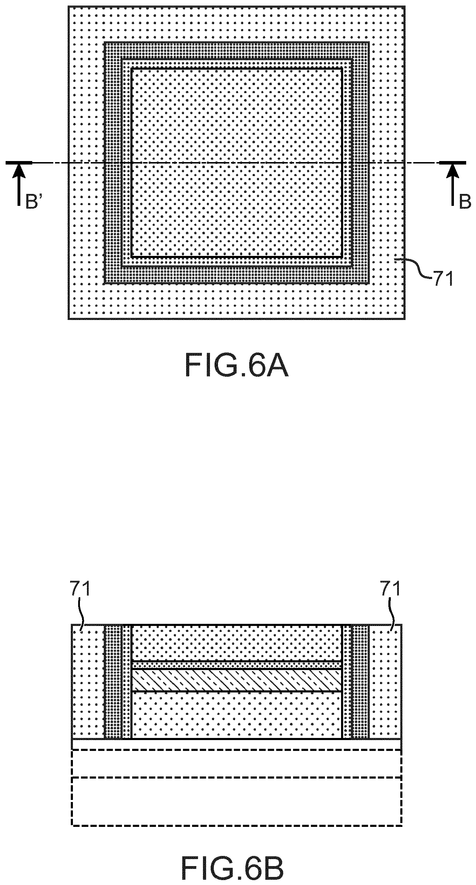

Ensuite, on forme une couche d'encapsulation 71 autour de la zone isolante 60 latérale. Cette couche d'encapsulation 71 est de préférence isolante et à base d'un matériau choisi de sorte à pouvoir résister à une gravure sélective du deuxième matériau diélectrique 62. Avantageusement, la couche d'encapsulation 71 peut être à base du premier matériau diélectrique 61, par exemple de l'oxyde de silicium (SiO₂). La couche d'encapsulation 71 peut être réalisée par dépôt puis par polissage ou planarisation CMP (pour « Chemical Mechanical Planarization ») en s'arrêtant sur la couche 53 de masquage (figures 6A et 6B donnant respectivement une vue de dessus et une vue en coupe suivant l'axe B'B).

Ensuite, on définit un emplacement de grille dans la première couche 53 de masquage.

Pour cela, on peut tout d'abord former une deuxième couche 83 de masquage recouvrant la première couche 53 de masquage, la zone isolante 60 et la couche d'encapsulation 71. La deuxième couche 83 de masquage et la première couche 53 de masquage peuvent être à base du même matériau. Avantageusement, le matériau de la deuxième couche 83 de masquage peut être également identique au deuxième matériau diélectrique 62 de la zone isolante latérale 60, par exemple à base de nitrure de silicium (SiN).

Pour réaliser l'emplacement de grille, on pratique ensuite au moins une ouverture 86 ayant la forme d'un motif de grille dans la deuxième couche 83 de masquage, puis dans la première couche 53 de masquage (figures 7A, 7B, 7C donnant respectivement une vue de dessus, une vue en coupe suivant l'axe B'B et une vue en coupe suivant l'axe C'C). L'ouverture 86 peut être réalisée au préalable dans un masque de résine 85 que l'on forme sur la deuxième couche 83 de masquage puis reproduite par gravure dans la deuxième couche 83 de masquage. L'ouverture 86 est disposée en regard d'au moins une portion de la zone isolante 60 à base du deuxième matériau diélectrique 62. Ainsi, comme cela est illustré sur la figure 7C, le prolongement de l'ouverture 86 peut avantageusement comprendre ou être accompagnée ou être suivie du retrait d'une portion de la zone isolante 60 dévoilée par l'ouverture 86, cette portion étant à base du deuxième matériau diélectrique 62. Ce retrait peut être réalisé par gravure sélective du deuxième matériau diélectrique 62 vis-à-vis du premier matériau diélectrique 61. On forme ainsi au moins un premier trou dans la zone isolante 60 qui s'étend parallèlement aux faces latérales du bloc 39 entre la couche d'encapsulation 71 et la première couche diélectrique de la zone isolante 60.

Dans l'exemple de réalisation illustré sur la figure 7C, plusieurs premiers trous 87a, 87b sont formés de part et d'autre du bloc 39 et communiquent avec l'ouverture 86 dans laquelle un emplacement pour une grille de transistor est prévu.

Lorsque les couches 53, 83 de masquage sont également à base du deuxième matériau diélectrique 62, la réalisation de l'ouverture 86 et du ou des premiers trous 87a, 87b peut être effectuée lors d'une même étape de gravure sélective par exemple à l'aide de procédés de gravure sèche. Lorsque le fond des premiers trous 87a, 87b réalisés atteint la couche de protection 31, on retire celle-ci, de sorte à dévoiler le premier niveau d'interconnexion du premier niveau N₁ de composants, et en particulier une zone de connexion 24 appartenant à ce niveau N₁.

On peut ensuite former une grille sacrificielle 90 dans l'ouverture 86, en utilisant par exemple un procédé de type Damascène. Cette grille sacrificielle 90 est dans ce cas destinée à être remplacée ultérieurement. Le matériau de la grille sacrificielle 90 est de préférence non-métallique et par exemple semi-conducteur, afin de limiter les possibilités de contamination lors d'étapes ultérieures et en particulier lors de la réalisation de régions de source et de drain par épitaxie.

Ainsi, après avoir retiré le masque de résine 85, on remplit l'ouverture 86 et les premiers trous 87a, 87b d'un matériau sacrificiel 88. Le matériau sacrificiel 88 de remplissage peut être par exemple du polysilicium. On peut ensuite effectuer une étape de polissage ou de planarisation CMP pour supprimer le matériau sacrificiel 88 en excédent débordant de l'embouchure de l'ouverture 86.

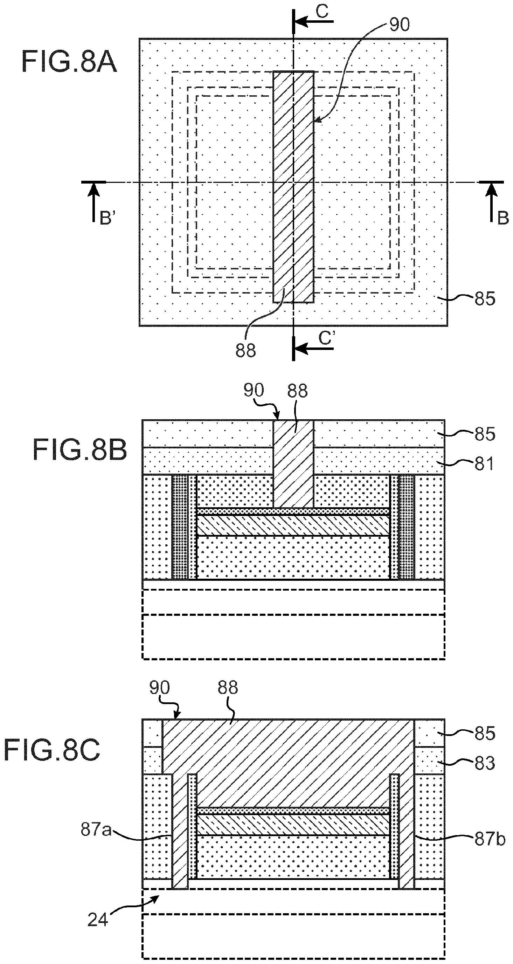

Les figures 8A, 8B, et 8C donnent des vues respectivement selon une vue de dessus, selon une vue en coupe suivant un axe B'B, selon une vue en coupe suivant un axe C'C, de l'ouverture 86 et des trou 87a, 87b rempli(s) de matériau sacrificiel 88.

On retire ensuite les parties restantes de la deuxième couche 83 de masquage puis de la première couche de masquage 53.

Ce retrait peut être suivi d'une gravure de la couche 51 de diélectrique de grille de sorte à former une zone de diélectrique de grille sous la grille sacrificielle 90.

Des espaceurs isolants 89, par exemple en nitrure de silicium, sont ensuite réalisés de part et d'autre de la grille sacrificielle 90 contre ses flancs latéraux.

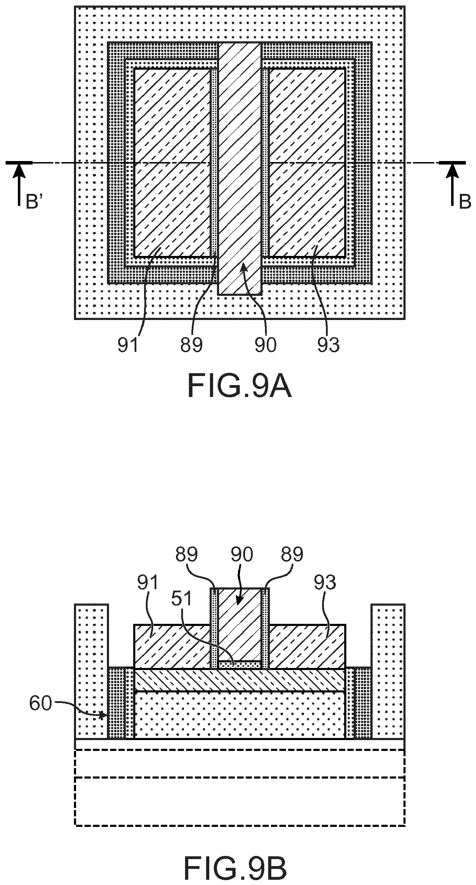

Puis, on forme des régions semi-conductrices de source 91 et de drain 93 de part et d'autre de la grille sacrificielle (figure 9A donnant une vue de dessus, figure 9B donnant une vue en coupe suivant l'axe B'B). Les régions semi-conductrices 91, 93 peuvent être réalisées par épitaxie sur la deuxième couche semi-conductrice 42. Un dopage des régions de source et de drain peut être également réalisé. Ce dopage peut être par exemple réalisé *in situ,* i.e. pendant la croissance du matériau semi-conducteur.

En variante, le dopage de régions de source et de drain est réalisé par implantation. La figure 9B montre des portions restantes de la zone isolante 60 conservées autour du bloc.

On remplace ensuite la grille sacrificielle 90, par une autre grille 120.

Pour cela, on peut former tout d'abord un masque isolant par exemple à base d'une couche isolante 101 qui peut être par exemple à base d'un matériau identique ou semblable au premier diélectrique 61, par exemple un matériau de type FOX pour « Field OXide » à base de SiO₂. Puis, on retire une épaisseur de cette couche isolante 101 jusqu'à dévoiler une face dite « supérieure » de la grille sacrificielle.

On peut ensuite retirer le matériau sacrificiel 88 de l'ouverture 86 et du trou 87. Dans le cas où le matériau sacrificiel 88 est à base de polySi, le retrait peut être réalisé par exemple à l'aide de procédés de gravure sèche. Le masque isolant 101 protège l'empilement de cette gravure.

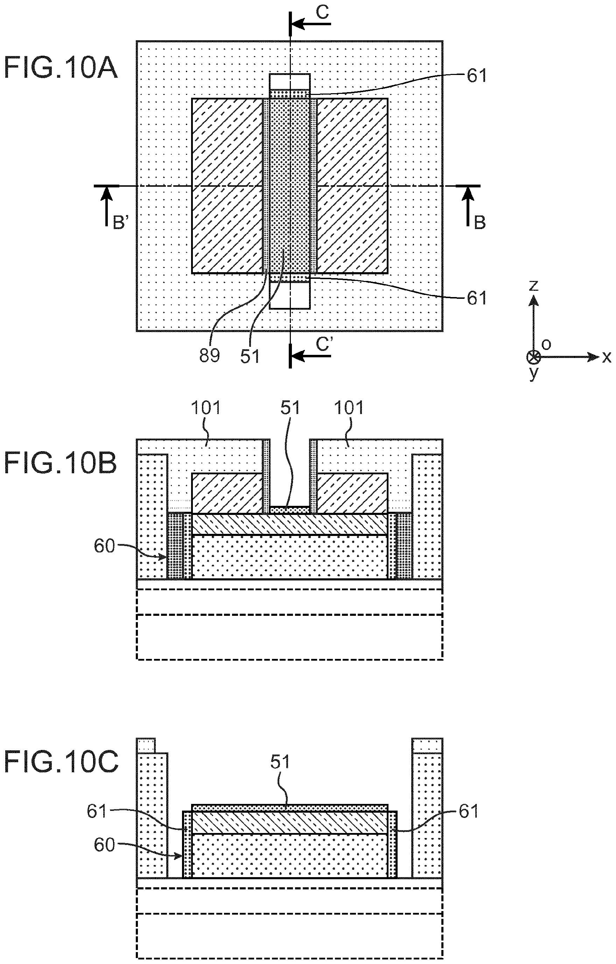

Les figures 10A, 10B, 10C (donnant respectivement une vue de dessus, une vue en coupe suivant l'axe B'B, une vue en coupe suivant l'axe C'C) illustrent le dispositif en cours de réalisation après retrait du matériau sacrificiel 88. Les trous 87a, 87b ayant été vidés, le fond des trous 87a, 87b dévoile à nouveau la zone 24 de connexion au premier niveau N₁ de composants.

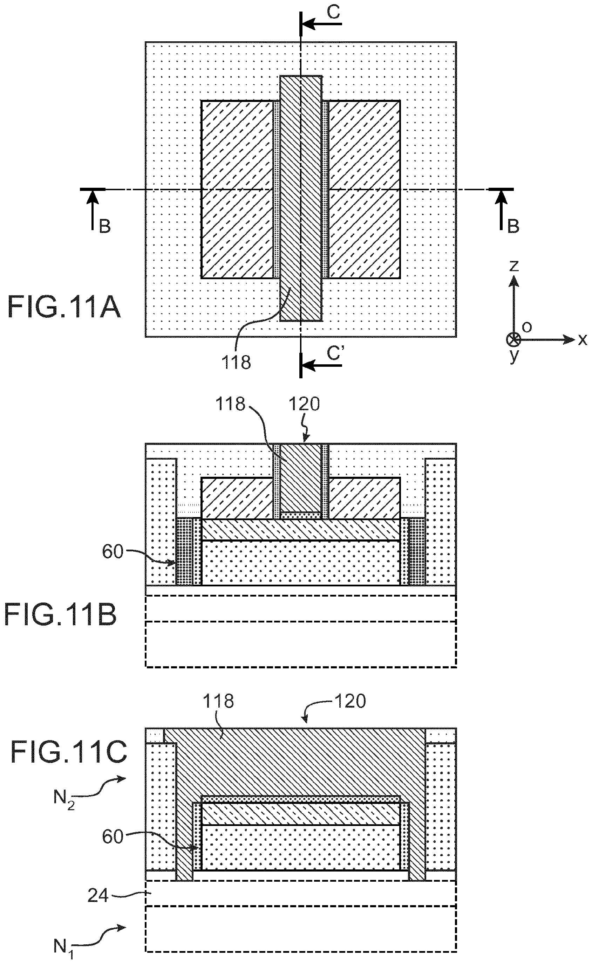

On remplace ensuite le matériau sacrificiel 88 par un matériau conducteur 118 par exemple un matériau métallique tel que du TiN/W, du W, pour former la grille 120 de remplacement (figures 11A, 11B, 11C donnant respectivement une vue de dessus, une vue en coupe suivant l'axe B'B, une vue en coupe suivant l'axe C'C).

Le remplissage des trous 87a, 87b par le matériau conducteur 118 permet de former des premiers éléments 130a, 130b d'interconnexion en contact avec une zone de connexion donnée 24. Le remplissage est effectué de sorte que le matériau conducteur 118 déborde des trous 87a, 87b et s'étend sur le diélectrique de grille parallèlement à la deuxième couche semi-conductrice 42 afin de former la grille 120. On établit ainsi un contact entre la grille d'un transistor T₂₁ du deuxième niveau N₂ de composants et le premier niveau d'interconnexion.

On peut ensuite également former d'autres éléments d'interconnexion cette fois entre la région de source 91 ou de drain 93 du transistor T₂₁ du deuxième niveau N₂ de composants et le premier niveau Ni de composants.

Pour cela on peut former tout d'abord un autre masque isolant 131 par exemple à base de SiO₂ à travers lequel on pratique un ou plusieurs trous 147a, 147b.

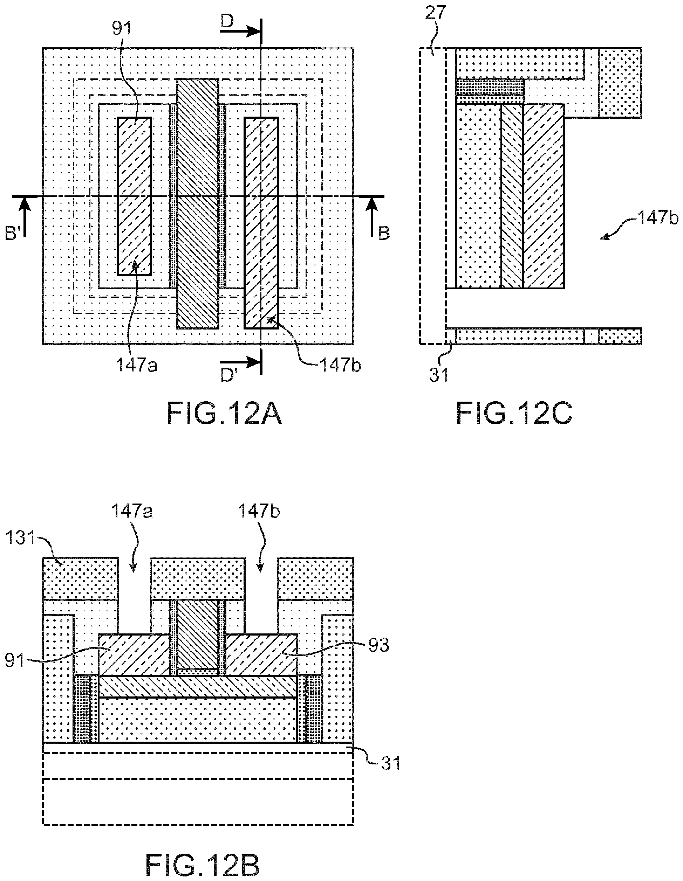

Dans l'exemple des figures 12A, 12B, 12D (donnant respectivement une vue de dessus, une vue en coupe suivant l'axe B'B, une vue en coupe suivant l'axe D'D) un trou 147a traverse les masques isolants 131, 101 et comporte un fond dévoilant la région semi-conductrice 91 de source, tandis qu'un autre trou 147b dévoile la région semi-conductrice 93 de drain du transistor T₂₁ appartenant au deuxième niveau N₂. La réalisation de cet autre trou 147b comprend le retrait d'une portion de la zone isolante 60, de la couche de protection 31 jusqu'à dévoiler une zone de connexion 27 du premier niveau Ni d'interconnexion. Cette zone 27 peut être distincte et isolée électriquement de la zone de connexion 24 à laquelle la grille est connectée par le biais de l'élément d'interconnexion 130. Dans cet exemple, les trous 147a, 147b, pratiqués dans les masques isolants 131, 101 sont prévus avec des dimensions différentes, le trou 147a s'étendant uniquement en regard de la région de source, tandis que l'autre trou 147b, de longueur plus importante s'étend en regard de la région de drain, et au-delà de la région de drain également en regard de la zone de connexion 27 du premier niveau N₁ d'interconnexion.

On peut ensuite former des zones d'alliage de métal et de semi-conducteur sur les zones des régions semi-conductrices 91 de source et de drain 93 dévoilées par les trous 147a, 147b. Pour cela on dépose un matériau métallique dans les trous 147a, 147b puis on effectue un recuit thermique afin de réaliser une siliciuration des régions semi-conductrice 91, 93.

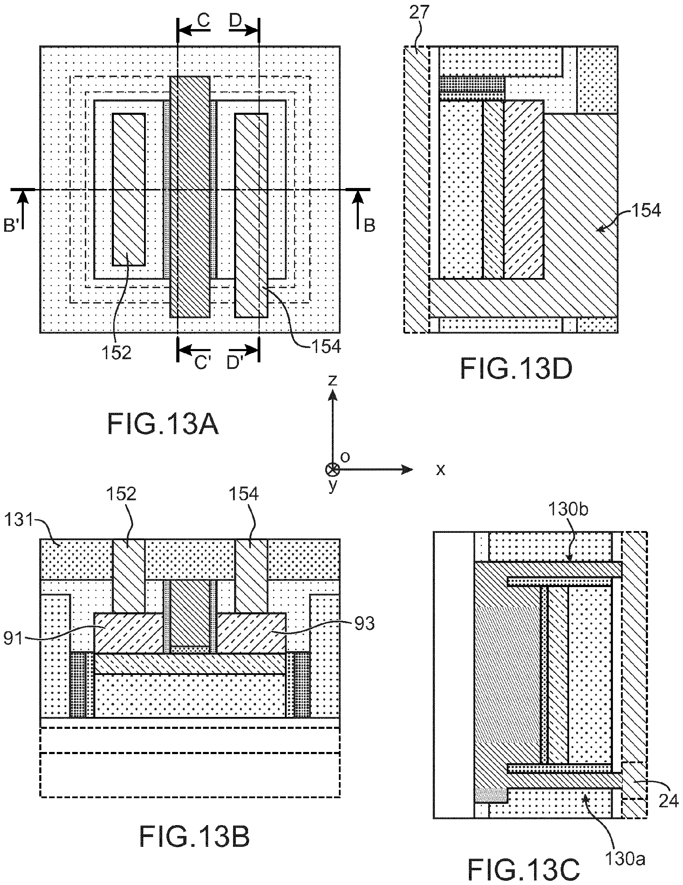

Un remplissage des trous 147a, 147b à l'aide d'un matériau conducteur tel que par exemple du TiN/W, W puis une étape de polissage par exemple par CMP est ensuite réalisé (figures 13A, 13B, 13C, 13D donnant respectivement une vue de dessus, une vue en coupe suivant l'axe B'B, une vue en coupe suivant l'axe C'C, une vue en coupe suivant l'axe D'D).

Le remplissage des trous 147a, 147b par un matériau conducteur permet de former un élément 152 d'interconnexion en contact avec la région de source 91 et un élément 154 d'interconnexion connexion en contact avec la région de drain 93 du transistor T₂₁. Du fait de la configuration du trou 147b et de son dépassement par rapport à la région de drain 93, l'élément 154 d'interconnexion est également connecté à la zone 27 de connexion. On établit ainsi un contact entre le drain du transistor T₂₁ du deuxième niveau N₂ de composants et le premier niveau d'interconnexion N₁.

Une variante prévoit de réaliser l'élément d'interconnexion 154 sur la région de source et l'élément d'interconnexion 152 sur la région de drain du transistor T₂₁.

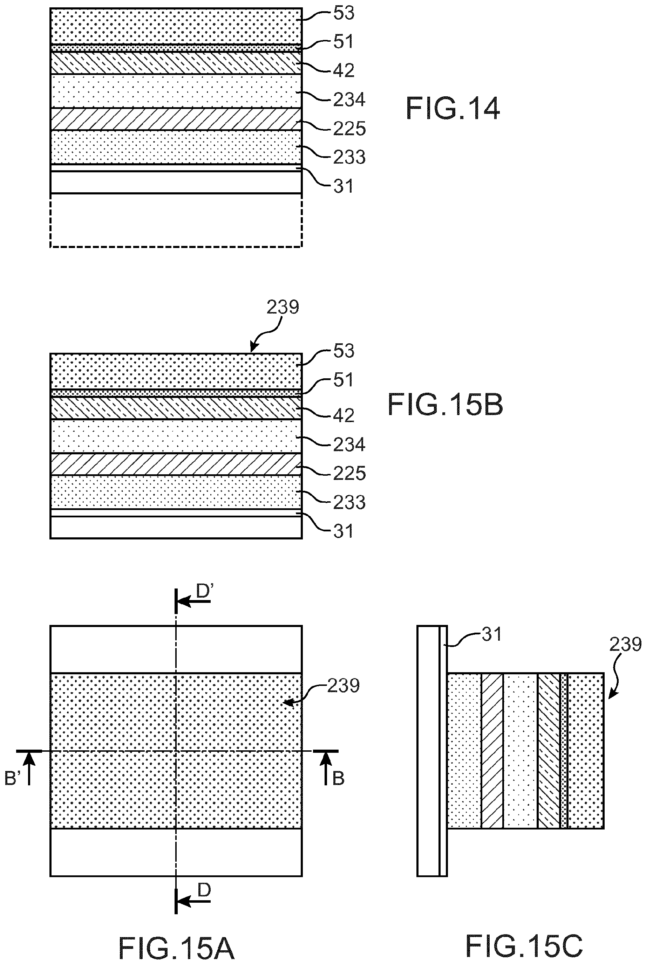

Une autre variante de réalisation de l'un ou l'autre des exemples de réalisation décrits précédemment prévoit de former l'empilement de couches réalisé sur le premier niveau Ni avec une couche conductrice 225 supplémentaire apte à former une électrode entre la deuxième couche semi-conductrice 42 et le premier niveau N₁ de composants (figure 14). Cette couche 225 peut être à base de matériau semi-conducteur dopé, par exemple du polysilicium dopé. Le dopage peut être réalisé durant la réalisation de la couche ou bien ultérieurement.

En fonction de la manière dont elle est polarisée et de son type de dopage, cette couche 225 supplémentaire peut être destinée à permettre de moduler la tension de seuil d'un ou plusieurs transistors du deuxième niveau N₂ de composants dont la région de canal est prévue dans la deuxième couche semi-conductrice 42. La couche conductrice 225 supplémentaire peut également servir de plan de masse pour le ou les transistors du deuxième niveau N₂.

Une telle couche conductrice 225 supplémentaire peut être réalisée notamment lorsque le ou les transistors du deuxième niveau N₂ sont formés selon une technologie de type SOI totalement désertée également appelée FDSOI (pour « Fully Depleted Silicon On Insulator »).

Pour intégrer cette zone conductrice supplémentaire 225, on peut prévoir un empilement tel qu'illustré sur la figure 14 qui comporte une couche isolante 233 entre le premier niveau N₁ de composants et la couche conductrice 225 supplémentaire, cette couche conductrice 225 pouvant être par exemple à base de polysilicium ou de métal. La couche isolante 233 peut être par exemple à base d'oxyde de silicium et avoir une épaisseur comprise par exemple entre 50 nm-120 nm.

Sur la couche conductrice 225, une autre couche isolante 234 est disposée et sépare cette couche conductrice 225 de la deuxième couche semi-conductrice 42. Cette autre couche isolante 234 est configurée, en particulier en termes de matériau la composant et d'épaisseur, de sorte à permettre un couplage capacitif entre la couche conductrice 225 et la deuxième couche semi-conductrice 42.

L'autre couche isolante 234 peut être par exemple à base d'oxyde de silicium et avoir une épaisseur comprise par exemple entre 10 nm et 25 nm.

L'empilement réalisé est ensuite gravé de manière à définir un bloc 239 (figures 15A, 15B, 15C donnant respectivement une vue de dessus, une vue en coupe suivant un axe B'B et une vue en coupe suivant un axe D'D). Cette gravure peut être effectuée par exemple à l'aide de procédés de gravure sèche avec arrêt sur la couche de protection 31.

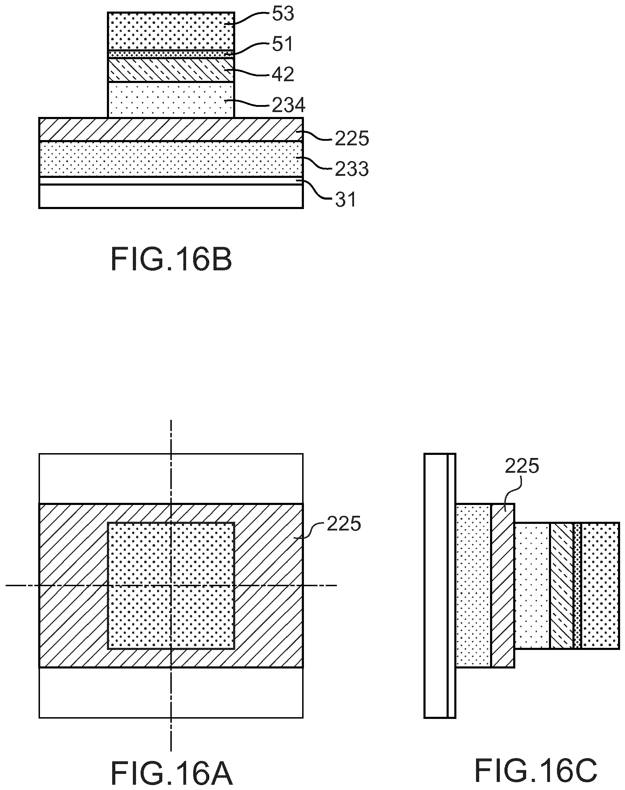

On grave ensuite à nouveau l'empilement de manière à définir dans la deuxième couche semi-conductrice 42 une zone active (figure 16A, 16B, 16C donnant respectivement une vue de dessus, une vue en coupe suivant un axe B'B et une vue en coupe suivant un axe D'D). Cette nouvelle gravure est réalisée en s'arrêtant sur la zone conductrice supplémentaire 225 et menée de manière à dévoiler au moins une région de la face supérieure de cette couche conductrice 225. Dans le bloc 239, cette région dévoilée de la couche conductrice 225 dépasse par rapport à la deuxième couche semi-conductrice, de manière à former un décrochement. La région dévoilée de la couche conductrice 225 est ainsi configurée de manière à permettre une prise de contact sur la couche conductrice 225 jouant le rôle d'électrode arrière de commande ou de plan de masse.

Ensuite, on peut effectuer des étapes telles que dans le procédé décrit précédemment notamment de réalisation de la zone isolante latérale autour du bloc 239, de formation de premiers trous dans la zone isolante latérale et d'un emplacement de grille communicant avec ces premiers trous, grille sacrificielle sur la deuxième couche semi-conductrice 42, de formation de régions de source et de drain sur la deuxième couche semi-conductrice 42, puis de remplacement de la grille sacrificielle par une autre grille.

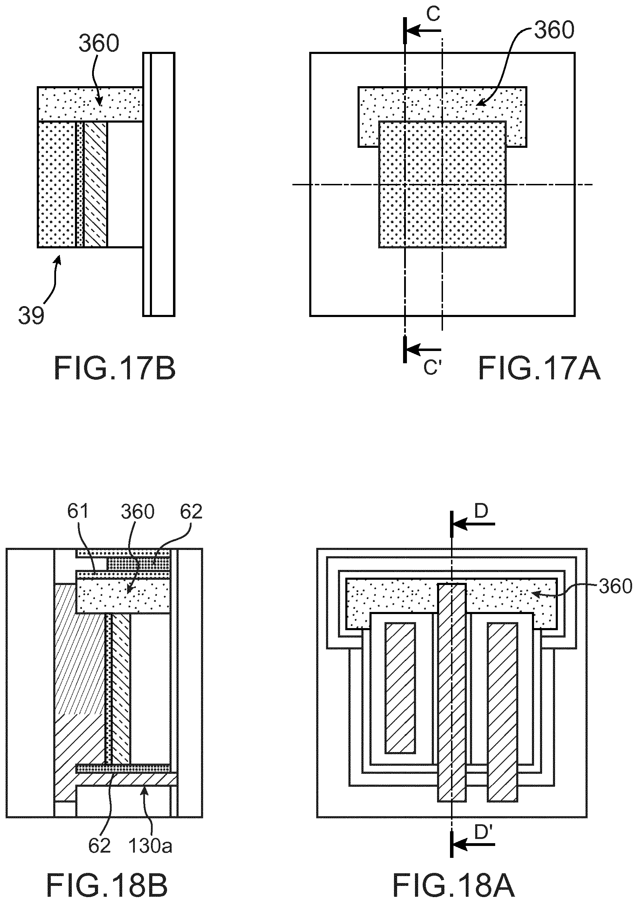

Selon une variante de réalisation de l'un ou l'autre des exemples de procédé qui viennent d'être décrits, préalablement à la réalisation de la zone isolante 60 latérale, on peut former un bouchon isolant 360 contre le bloc 39, de sorte à recouvrir au moins une région d'une face latérale du bloc 39. Ce bouchon isolant 360 est prévu à base d'un matériau diélectrique différent du deuxième matériau diélectrique 62 à partir duquel la deuxième couche diélectrique de la zone isolante 60 est formée et susceptible de résister à une gravure sélective du deuxième matériau diélectrique 62 (figures 17A, 17B donnant respectivement une vue de dessus, une vue en coupe suivant un axe C'C du dispositif en cours de réalisation). Le bouchon isolant 360 peut être par exemple à base d'oxyde de silicium lorsque le deuxième matériau diélectrique 62 est à base de nitrure de silicium.

Ensuite, on peut former la zone isolante 60 latérale autour du bloc 39 et du bouchon isolant 360 et suivre des étapes semblables à celles décrites en liaison avec les figures 6 à 12.

Dans la région dans laquelle il est disposé, le bouchon isolant 360 permet d'éviter la formation de trou par gravure d'une portion de la zone isolante latérale 60. Ainsi, pour un même motif de grille que celui de l'exemple de réalisation décrit précédemment en liaison avec la figure 13A, on réalise cette fois un seul élément d'interconnexion 130a le long d'une face latérale du bloc, tout en empêchant une prise de contact au niveau d'une région d'une face latérale recouverte par le bouchon isolant 360.

L'un ou l'autre des exemples de réalisation particuliers qui viennent d'être décrits concernent la réalisation d'éléments d'interconnexion entre un premier niveau de transistors et un deuxième niveau de transistors mais peut s'appliquer à la mise en oeuvre d'un circuit 3D comportant plus de deux niveaux ou à l'interconnexion d'un transistor d'un niveau donné avec d'autres types de composants d'un niveau inférieur.

## Revendications

1. Procédé de réalisation d'au moins un élément d'interconnexion entre des niveaux différents de composants d'un circuit intégré doté de plusieurs niveaux (N₁, N₂) superposés de composants électroniques, le procédé comprenant des étapes consistant à :
a) former sur un niveau inférieur (N₁) doté d'une ou plusieurs zones de connexion et d'au moins un premier composant (T₁₁) réalisé au moins partiellement dans une première couche semi-conductrice (11) : un bloc (39) comprenant une deuxième couche semi-conductrice (42) dans laquelle au moins une région de canal d'au moins un transistor (T₂₁) d'un niveau supérieur (N₂) est apte à être au moins partiellement formé et une couche isolante (33, 234) agencée entre la première couche semi-conductrice (11) et la deuxième couche semi-conductrice (42),
b) former une zone isolante (60) latérale contre une face latérale du bloc (39) de sorte que la zone isolante latérale repose sur une première zone de connexion (24) du niveau inférieur, la zone isolante latérale (60) étant formée d'au moins une première couche diélectrique à base d'un premier matériau diélectrique (61) et d'au moins une deuxième couche diélectrique à base d'un deuxième matériau diélectrique (62) apte à être gravé de manière sélective vis-à-vis du premier matériau diélectrique (61), la première couche diélectrique étant disposée en contact de la deuxième couche semi-conductrice (42) et étant revêtue par la deuxième couche diélectrique, puis
former une couche d'encapsulation (71) autour de la zone isolante (60) latérale, puis
c) retirer une portion de la zone isolante latérale (60) de sorte à former au moins un trou (87) doté d'un fond dévoilant ladite première zone de connexion (24), la portion retirée étant une portion de la deuxième couche diélectrique gravée sélectivement vis-à-vis de la première couche diélectrique de sorte à conserver le premier matériau diélectrique (61) entre le premier trou (87) et la deuxième couche semi-conductrice (42), la couche d'encapsulation (71) étant à base d'un matériau apte à résister à la gravure sélective du deuxième matériau diélectrique (62),
d) remplir le trou (87) à l'aide d'un matériau conducteur, le matériau conducteur étant agencé de sorte à former au moins un élément d'interconnexion entre une électrode du transistor (T₂₁) et ladite première zone de connexion (24), l'électrode étant une électrode de grille (120) du transistor (T₂₁).

2. Procédé selon la revendication 1, comprenant en outre des étapes de :
- formation d'au moins un autre trou (147b) par gravure d'au moins une autre portion de la zone isolante (60) latérale, l'autre trou (147b) étant agencé de sorte à dévoiler une zone de la deuxième couche semi-conductrice destinée à former une région de source ou de drain, et au moins une deuxième zone (27) de connexion du niveau inférieur (N₁),
- remplissage de l'autre trou (147b) par un matériau conducteur de sorte à former au moins un autre élément de connexion (154) entre une électrode de source ou de drain du transistor et la deuxième zone de connexion du niveau inférieur (N₁).

3. Procédé selon l'une des revendications 1 ou 2, dans lequel on forme en outre au moins une couche de masquage (53, 83) en regard de la deuxième couche semi-conductrice (42) et au moins une ouverture (86) dans la couche de masquage, l'ouverture suivant un motif de grille, le premier trou (87) étant réalisé à l'étape c) de sorte à communiquer avec l'ouverture (86), le dépôt à l'étape d) comprenant le remplissage de ladite ouverture (86) par le matériau conducteur de sorte à former l'électrode de grille du transistor.

4. Procédé selon la revendication 3, dans lequel le bloc formé à l'étape a) comprend une couche de diélectrique (51) de grille disposée sur la deuxième couche semi-conductrice (42), l'ouverture (86) dévoilant la couche de diélectrique (51) de grille.

5. Procédé selon la revendication 3 ou 4, dans lequel la couche de masquage est en contact avec la deuxième couche diélectrique.

6. Procédé selon l'une des revendications 1 à 5, dans lequel après formation de la zone isolante latérale (60), le procédé comprend des étapes de :
- formation sur la deuxième couche semi-conductrice d'une grille sacrificielle (90) à base d'un matériau sacrificiel, puis
- croissance de régions de source (91) et de drain (93) sur la couche semi-conductrice, puis
- remplacement de la grille sacrificielle (90) par une autre grille (120), l'autre grille étant l'électrode de grille qui est ainsi formée à l'étape d) à base dudit matériau conducteur.

7. Procédé selon l'une des revendications 1 à 6, dans lequel le bloc comprend une couche (225) apte à former une électrode située entre le niveau inférieur (N₁) et la deuxième couche semi-conductrice (42), la couche (225) apte à former une électrode étant destinée, en fonction de la manière dont elle est polarisée, à contrôler la tension de seuil dudit transistor, la couche (225) apte à former une électrode étant revêtue par la couche isolante (234), et étant agencée en outre en regard de la deuxième couche semi-conductrice (42) et de sorte que la couche isolante (234) sépare la deuxième couche semi-conductrice (42) de la couche apte à former une électrode (225), la couche isolante (234) ayant une épaisseur et étant à base d'un matériau prévus de sorte à permettre un couplage capacitif entre la couche (225) apte à former une électrode et la deuxième couche semi-conductrice (42).

8. Procédé selon la revendication 7, dans lequel la couche conductrice (225) dépasse dans le bloc par rapport à la deuxième couche semi-conductrice (42), de manière à former un décrochement.

9. Procédé selon l'une des revendications 1 à 8, dans lequel le procédé comprend en outre, entre l'étape a) et l'étape b) : la formation d'un bouchon isolant (360) contre au moins une autre face latérale du bloc, ladite face latérale n'étant pas recouverte par le bouchon isolant.

10. Procédé selon l'une des revendications 1 à 9, dans lequel la zone isolante latérale formée à l'étape b) entoure entièrement le bloc.

11. Procédé selon l'une des revendications 1 à 10, dans lequel une couche de protection (31) est disposée sur le niveau inférieur préalablement à la formation du bloc à l'étape a), la couche de protection étant formée du premier matériau diélectrique et du deuxième matériau diélectrique.

## Patentansprüche

1. Verfahren zur Herstellung wenigstens eines Verbindungselements zwischen verschiedenen Niveaus von Komponenten einer integrierten Schaltung, die mit mehreren überlagerten Niveaus (N₁, N₂) von elektronischen Komponenten ausgestattet ist, wobei das Verfahren die folgenden Schritte umfasst:
a) Bilden von Folgendem auf einen unteren Niveau (N₁), das mit einer oder mehreren Verbindungszonen und mit wenigstens einer ersten Komponente (T₁₁) ausgestattet ist, die wenigstens teilweise in einer ersten Halbleiterschicht (11) realisiert ist: einem Block (39), umfassend eine zweite Halbleiterschicht (42), in der wenigstens eine Kanalregion wenigstens eines Transistors (T₂₁) eines oberen Niveaus (N₂) wenigstens teilweise gebildet werden kann, und einer isolierenden Schicht (33, 234), die zwischen der ersten Halbleiterschicht (11) und der zweiten Halbleiterschicht (42) angeordnet ist,
b) Bilden einer lateralen isolierenden Zone (60) gegen eine laterale Fläche des Blocks (39) derart, dass die laterale isolierende Zone auf einer ersten Verbindungszone (24) des unteren Niveaus ruht, wobei die laterale isolierende Zone (60) mit wenigstens einer ersten dielektrischen Schicht auf Basis eines ersten dielektrischen Materials (61) und mit wenigstens einer zweiten dielektrischen Schicht auf Basis eines zweiten dielektrischen Materials (62) gebildet ist, das hinsichtlich des ersten dielektrischen Materials (61) auf selektive Weise geätzt werden kann, wobei die erste dielektrische Schicht in Kontakt mit der zweiten Halbleiterschicht (42) angeordnet ist und durch die zweite dielektrische Schicht bedeckt ist, und dann
Bilden einer Einkapselungsschicht (71) um die laterale isolierende Zone (60) herum, und dann
c) Entfernen eines Bereichs der lateralen isolierenden Zone (60) derart, dass wenigstens ein Loch (87) gebildet wird, das mit einem Boden ausgestattet ist, der die erste Verbindungszone (24) freilegt, wobei der entfernte Bereich ein Bereich der zweiten dielektrischen Schicht ist, der selektiv hinsichtlich der ersten dielektrischen Schicht derart geätzt ist, dass das erste dielektrische Material (61) zwischen dem ersten Loch (87) und der zweiten Halbleiterschicht (42) bewahrt wird, wobei die Einkapselungsschicht (71) auf Basis eines Materials ist, das dazu ausgelegt ist, dem selektiven Ätzen des zweiten dielektrischen Materials (62) zu widerstehen,
d) Füllen des Lochs (87) mit Hilfe eines leitenden Materials, wobei das leitende Material dazu ausgelegt ist, wenigstens ein Verbindungselement zwischen einer Elektrode des Transistors (T₂₁) und der ersten Verbindungszone (24) zu bilden, wobei die Elektrode eine Gateelektrode (120) des Transistors (T₂₁) ist.

2. Verfahren nach Anspruch 1, ferner umfassend die folgenden Schritte:
- Bilden wenigstens eines anderen Lochs (147b) durch Ätzen wenigstens eines anderen Bereichs der lateralen isolierenden Zone (60), wobei das andere Loch (147b) dazu ausgelegt ist, eine Zone der zweiten Halbleiterschicht freizulegen, die eine Source- oder Drainregion bilden soll, sowie wenigstens eine zweite Zone (27) zur Verbindung des unteren Niveaus (N₁),
- Füllen des anderen Lochs (147b) mittels eines leitenden Materials derart, dass wenigstens ein anderes Verbindungselement (154) zwischen einer Source- oder Drain-Elektrode des Transistors und der zweiten Verbindungszone des unteren Niveaus (N₁) gebildet wird.

3. Verfahren nach einem der Ansprüche 1 oder 2, bei dem man ferner wenigstens eine Maskierungsschicht (53, 83) gegenüber der zweiten Halbleiterschicht (42) sowie wenigstens eine Öffnung (86) in der Maskierungsschicht bildet, wobei die Öffnung einem Gatemotiv folgt, wobei das erste Loch (87) im Schritt c) derart realisiert wird, dass es mit der Öffnung (86) kommuniziert, wobei die Aufbringung im Schritt d) das Füllen der Öffnung (86) mit dem leitenden Material derart umfasst, dass die Gate-Elektrode des Transistors gebildet wird.

4. Verfahren nach Anspruch 3, bei dem der im Schritt a) gebildete Block eine dielektrische Gate-Schicht (51) umfasst, die auf der zweiten Halbleiterschicht (42) angeordnet ist, wobei die Öffnung (86) die dielektrische Gate-Schicht (51) freilegt.

5. Verfahren nach Anspruch 3 oder 4, bei dem die Maskierungsschicht in Kontakt mit der zweiten dielektrischen Schicht ist.

6. Verfahren nach einem der Ansprüche 1 bis 5, bei dem das Verfahren nach der Bildung der lateralen isolierenden Zone (60) die folgenden Schritte umfasst:
- Bilden eines Opfergates (90) auf Basis eines Opfermaterials auf der zweiten Halbleiterschicht, dann
- Aufwachsen von Sourceregionen (91) und Drainregionen (93) auf der Halbleiterschicht, dann
- Ersetzen des Opfergates (90) durch ein anderes Gate (120), wobei das andere Gate die Gate-Elektrode ist, die somit im Schritt d) auf Basis des leitenden Materials gebildet wird.

7. Verfahren nach einem der Ansprüche 1 bis 6, bei dem der Block eine Schicht (225) umfasst, die dazu ausgelegt ist, eine Elektrode zu bilden, die sich zwischen dem unteren Niveau (N₁) und der zweiten Halbleiterschicht (42) befindet, wobei die Schicht (225), die eine Elektrode bilden kann, dazu bestimmt ist, als Funktion der Art, auf die sie polarisiert ist, die Schwellenspannung des Transistors zu steuern, wobei die Schicht (225), die eine Elektrode bilden kann, mit der isolierenden Schicht (234) bedeckt ist, und ferner gegenüber der zweiten Halbleiterschicht (42) und derart angeordnet ist, dass die isolierende Schicht (234) die zweite Halbleiterschicht (42) von der Schicht trennt, die eine Elektrode (225) bilden kann, wobei die isolierende Schicht (234) eine Dicke hat und auf Basis eines Materials ist, die derart vorgesehen sind, dass eine kapazitive Kopplung zwischen der Schicht (225), die eine Elektrode bilden kann, und der zweiten Halbleiterschicht (42) ermöglicht wird.

8. Verfahren nach Anspruch 7, bei dem die leitende Schicht (225) in dem Block bezüglich der zweiten Halbleiterschicht (42) derart übersteht, dass ein Absatz gebildet wird.

9. Verfahren nach einem der Ansprüche 1 bis 8, bei dem das Verfahren ferner zwischen dem Schritt a) und dem Schritt b) die Bildung eines isolierenden Verschlusses (360) gegen wenigstens eine andere laterale Fläche des Blocks umfasst, wobei die laterale Fläche nicht durch den isolierenden Verschluss bedeckt wird.

10. Verfahren nach einem der Ansprüche 1 bis 9, bei dem die laterale isolierende Zone, die im Schritt b) gebildet wird, den Block vollständig umgibt.

11. Verfahren nach einem der Ansprüche 1 bis 10, bei dem eine Schutzschicht (31) auf dem unteren Niveau vor der Bildung des Blocks im Schritt a) angeordnet wird, wobei die Schutzschicht aus dem ersten dielektrischen Material und dem zweiten dielektrischen Material gebildet wird.

## Claims

1. Method for manufacturing at least one interconnection element between different component levels in an integrated circuit provided with several superposed levels (N₁, N₂) of electronic components, the method including the following steps of:
a) forming, on a lower level (N₁) provided with one or several connection areas and at least one first component (T₁) made at least partially in a first semiconducting layer (11), at least one block (39) comprising a second semiconducting layer (42) in which at least one channel region of at least one transistor (T₂₁) in an upper level (N₂) can be at least partially formed and an insulating layer (33, 294) can be formed between the first semiconducting layer (11) and the second semiconducting layer (42);
b) forming a lateral insulating area (40) in contact with a lateral face of the block (39) such that the lateral insulating area is supported of a first connection area on the lower level, the lateral insulating area (60) being formed from at least a first dielectric layer based on a first dielectric material (61) and at least a second dielectric layer based on a second dielectric material (62) that can be selectively etched relative to the first dielectric material (61), the first dielectric layer being placed in contact with the second semiconducting layer (42) and being coated with the second dielectric layer; then forming an encapsulation layer (71) around the lateral insulating area (60);
c) removing a portion of the lateral insulating area (60) so as to form at least one hole (87) provided with a bottom exposing said first connection area (24), the removed portion being a portion of the second dielectric layer selectively etched relative to the first dielectric layer so as to maintain the first dielectric (61) material between the first hole (87) and the second semiconducting layer (42), the encapsulation layer (71) being based on a material able to resist selecting etching of the second dielectric material (62);
d) filling the hole (87) with a conducting material, the conducting material being placed so as to form at least one interconnection element between an electrode of the transistor (T₂₁) and said first connection area (24), the electrode being a gate electrode (120) of the transistor.

2. Method according to claim 1, further comprising steps of:
- forming at least one other hole (147b) by etching at least one other portion of the lateral insulating area (60), the other hole (147b) being arranged so as to expose an area of the second semiconducting layer designed to form a source or a drain region, and at least one second connection area (27) on the lower level (N₁),
- filling the other hole (147b) with a conducting material so as to form at least one other connection element (154) between a source or drain electrode of the transistor and a second connection area on the lower level (N₁).

3. Method according to one of claims 1 or 2, wherein at least one masking layer (53, 83) is further formed facing the second semiconducting layer (42) and at least one opening (86) is formed in the masking layer, the opening using a gate pattern, the first hole (87) being made in step c) so as to communicate with the opening (86), the deposit in step d) including filling of said opening (86) by the conducting material so as to form the gate electrode of the transistor.

4. Method according to claim 3, wherein the block formed in step a) comprises a gate dielectric layer (51) located on the second semiconducting layer (42), the opening (86) exposing the gate dielectric layer (51).

5. Method according to claim 3 or 4, wherein the masking layer is in contact with the second dielectric layer.

6. Method according to one of claims 1 to 5, wherein, after formation of the lateral insulating area (60), the method comprises steps of:
- forming a sacrificial gate (90) based on a sacrificial material, on the second semiconducting layer, then
- growing source (91) and drain (93) regions on the semiconducting layer, then
- replacing the sacrificial gate (90) by another gate (120), the other gate being the gate electrode formed in step d) based on said conducting material.

7. Method according to one of claims 1 to 6, wherein the block comprises a layer (225) able to form an electrode located between the lower level (N₁) and the second semiconducting layer (42), the layer (225) able to form an electrode being designed to control the threshold voltage of said transistor, depending on how it is biased, the layer (225) able to form an electrode being coated with the insulating layer (234), and being also located facing the second semiconducting layer (42) and such that the insulating layer (234) separates the second semiconducting layer (42) from the layer able to form an electrode (225), the insulating layer (234) having a thickness and being based on a material selected so as to enable capacitive coupling between the layer (225) able to form an electrode and the second semiconducting layer (42).

8. Method according to claim 7, wherein the conducting layer (225) projects from the second semiconducting layer (42) in the block, so as to form an offset.

9. Method according to one of claims 1 to 8, wherein the method further includes between step a) and step b) forming an insulating plug (360) in contact with at least one other lateral face of the block, said lateral face not being covered by the insulating plug.

10. Method according to one of claims 1 to 9, wherein the lateral insulating area formed in step b) entirely surrounds the block.

11. Method according to one of claims 1 to 10, wherein a protective layer (31) is located on the lower level before the formation of the block in step a), the protective layer being formed from the first dielectric material and the second dielectric material.
